# EUROPEAN PATENT SPECIFICATION

(11) **EP 4 489 071 B1**
(45) Date of publication and mention of the grant of the patent: **11.03.2026**
(21) Application number: 24185981.8
(22) Date of filing: 02.07.2024
(51) Int. Cl.: H01L 23/498, H01L 25/065, H01L 21/48, H01L 23/50

(54) **SEMICONDUCTOR DEVICE INCLUDING SEMICONDUCTOR PACKAGE WITH CAPACITOR EMBEDDED IN DIELECTRIC LAYER**
HALBLEITERBAUELEMENT MIT HALBLEITERGEHÄUSE MIT IN EINER DIELEKTRISCHEN SCHICHT EINGEBETTETEM KONDENSATOR
DISPOSITIF SEMI-CONDUCTEUR COMPRENANT UN BOÎTIER SEMI-CONDUCTEUR AVEC UN CONDENSATEUR INCORPORÉ DANS UNE COUCHE DIÉLECTRIQUE

(30) Priority: 03.07.2023 US 202363524746 P; 04.04.2024 US 202418626727
(43) Date of publication of application: 08.01.2025
(73) Proprietor: Samsung Electronics Co., Ltd., Suwon-si, Gyeonggi-do 16677 (KR)
(72) Inventor: YANG, Jin, San Jose, CA, 95134 (US)
(74) Representative: Kuhnen & Wacker Patent- und Rechtsanwaltsbüro PartG mbB

(56) References cited:
- US-A1- 2004 201 085
- US-A1- 2006 087 029
- US-A1- 2017 207 147
- US-A1- 2022 199 520
- JATLAOUI MOHAMED MEHDI ET AL: "Multi-terminal Ultra-thin 3D Nanoporous Silicon Capacitor Technology for High-Speed Circuits Decoupling", 2022 IEEE 72ND ELECTRONIC COMPONENTS AND TECHNOLOGY CONFERENCE (ECTC), IEEE, 31 May 2022 (2022-05-31), pages 908 - 913, XP034147609, [retrieved on 20220712], DOI: 10.1109/ECTC51906.2022.00148

## Description

### BACKGROUND

### 1. Field

Apparatuses and methods related to a semiconductor device including a semiconductor package in which a capacitor is embedded in a dielectric layer of a redistribution layer.

### 2. Description of the Related Art

As the demand for a semiconductor device including a high device density and high device performance increases, a semiconductor package including a plurality of semiconductor chips and a connections structure such as a redistribution layer is also required to serve high performance of a semiconductor device including the semiconductor package. However, when a semiconductor package is provided with one or more passive devices such as capacitors and resistors, a semiconductor device including one or more of the semiconductor package may have a correspondingly increased size.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

US 2004/201085 A1 discloses the following: A multi-chip circuit module on which semiconductor chips are loaded and which is provided with circuit patterns, input/output terminals or the like for interconnecting the semiconductor chips. A multilayered wiring section is formed by respective unit wiring layers in such a manner that an upper unit wiring layer is layered on a surface-planarized subjacent unit wiring layer and connected to one another by inter-layer connection by a via-on-via structure. A semiconductor chip mounted on this multi-layer wiring section is polished along with the sealing resin layer for reducing the thickness.

US 2017/207147 A1 discloses the following: A semiconductor device includes a plurality of redistribution layers, a dielectric layer, and a conductive structure. The redistribution layers are formed overlying a device die to provide an electrical connection between the device die and an external connector in a package. The dielectric layer is arranged between the redistribution layers to form a capacitor structure. The conductive structure is formed and coupled between the device die and the redistribution layers.

US 2006/087029 A1 discloses the following: A semiconductor device includes a semiconductor chip having a surface provided with connecting electrodes, a stacked structure made up of alternately stacked dielectric and wiring layers and provided on the surface of the semiconductor chip, a passive element provided in the stacked structure and electrically connected to the wiring layers; and external electrodes for external electrical connection provided on the stacked structure and electrically connected to the connecting electrodes via the wiring layers. The passive element has at least one layer selected from a group consisting of a capacitor dielectric layer, a resistor layer and a conductor layer that are formed by spraying an aerosol particulate material.

US 2022/199520 A1 discloses the following: A semiconductor package includes a support substrate having connection wirings disposed therein. At least one capacitor is disposed on the support substrate. The capacitor has first and second electrodes that are exposed from an upper surface of the support substrate. A redistribution wiring layer covers the upper surface of the support substrate. The redistribution wiring layer has redistribution wirings electrically connected to the connection wirings and the first and second electrodes respectively. A semiconductor chip is disposed on the redistribution wiring layer. The semiconductor chip has chip pads that are electrically connected to the redistribution wirings and outer connectors disposed on a lower surface of the support substrate and electrically connected to the connection wirings.

### SUMMARY

The invention is set out in the appended claims.

According to one or more embodiments, there is provided a semiconductor device which includes:
a redistribution layer including at least one insulation layer in which a plurality of wiring patterns are formed; at least one semiconductor chip disposed above or below the redistribution layer, and connected to at least one of the plurality of wiring patterns; and at least one capacitor disposed in the redistribution layer. Here, the capacitor is an ISC.

According to one or more embodiments, the capacitor may be disposed in the redistribution layer to be closer to a top surface of the redistribution layer facing the semiconductor chip than a bottom surface of the redistribution layer facing away from the semiconductor chip.

According to embodiments, the capacitor may be disposed in the at least one insulation layer such that one of a top surface and a bottom surface of the first capacitor is within the at least one insulation layer, and the other of the top surface and the bottom surface is within the at least one insulation layer or coplanar with a top surface or a bottom surface of the at least one insulation layer

### BRIEF DESCRIPTION OF DRAWINGS

Example embodiments of the inventive concept will be more clearly understood from the following detailed description taken in conjunction with the accompanying drawings in which:
FIG. 1 illustrates a schematic cross-section side view of semiconductor package including a plurality of decoupling capacitors, according to an embodiment;
FIG. 2 illustrates a schematic cross-section side view of semiconductor package including a plurality of decoupling capacitors, according to another embodiment;
FIG. 3 illustrates a schematic cross-section side view of semiconductor package including a plurality of decoupling capacitors, according to still another embodiment;
FIG. 4 illustrates a flowchart for a method of manufacturing a semiconductor package including one or more ISCs, according to embodiments; and
FIGS. 5A-5G illustrate intermediate semiconductor packages after respective steps of manufacturing a semiconductor package including one or more ISCs based on the flowchart of FIG. 4, according to embodiments;

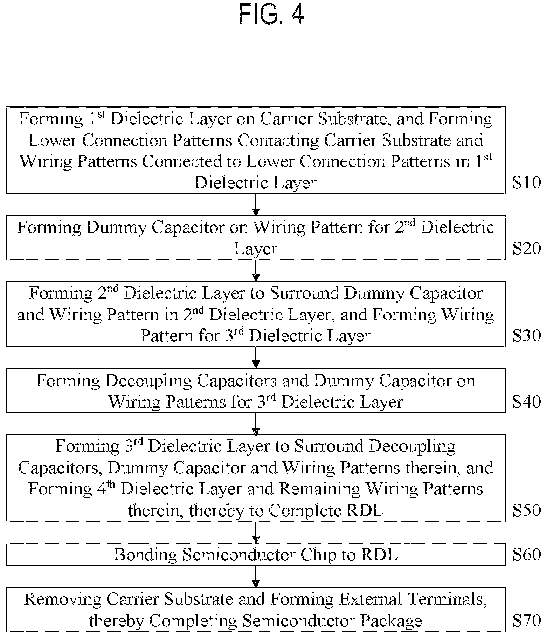

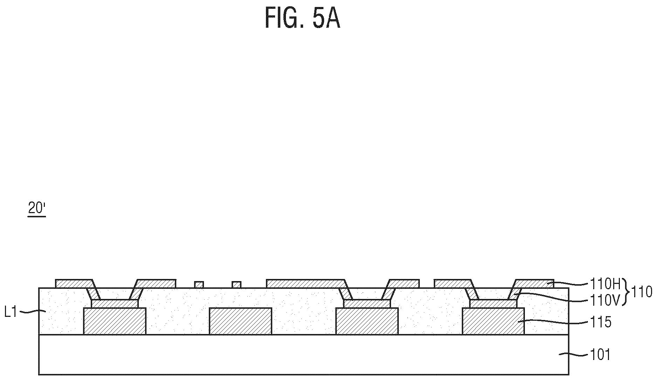

FIG. 5A illustrates an intermediate semiconductor package after step 10 of FIG. 4, according to an embodiment;

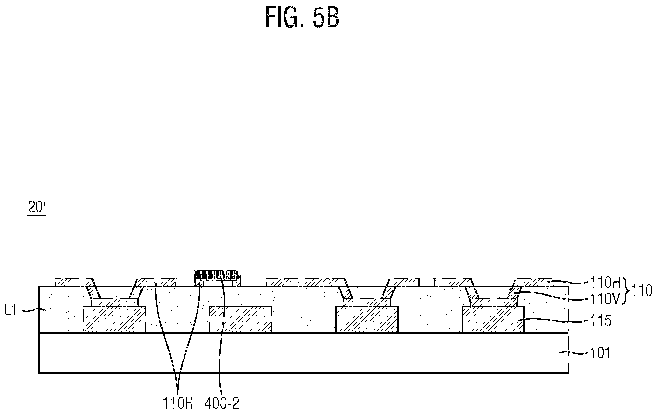

FIG. 5B illustrates an intermediate semiconductor package after step 20 of FIG. 4, according to an embodiment;

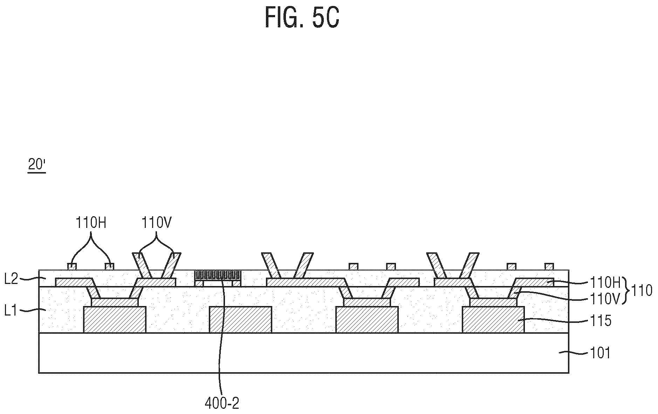

FIG. 5C illustrates an intermediate semiconductor package after step 30 of FIG. 4, according to an embodiment;

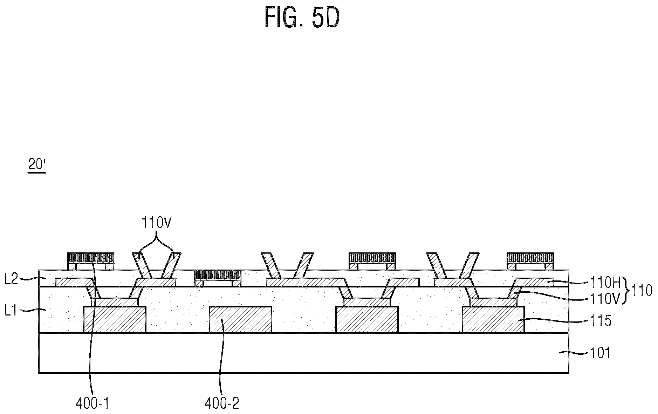

FIG. 5D illustrates an intermediate semiconductor package after step 40 of FIG. 4, according to an embodiment;

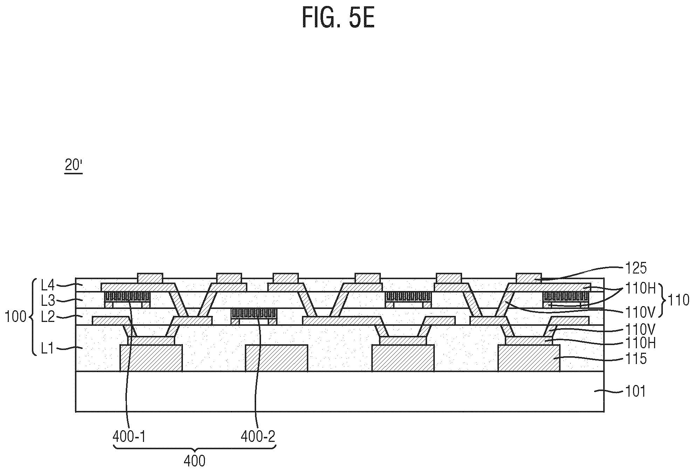

FIG. 5E illustrates an intermediate semiconductor package after step 50 of FIG. 4, according to an embodiment;

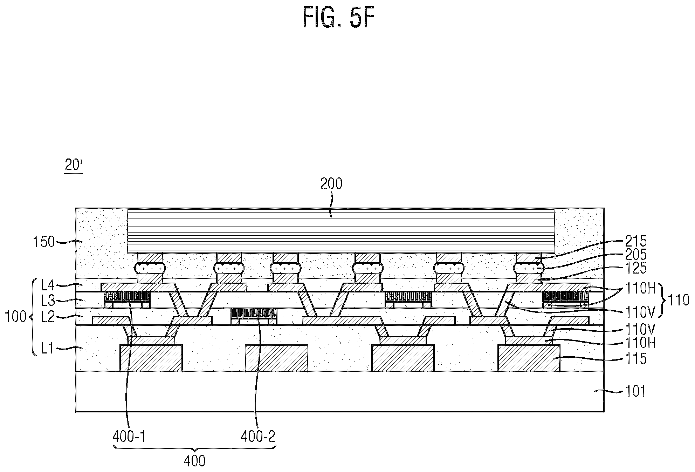

FIG. 5F illustrates an intermediate semiconductor package after step 60 of FIG. 4, according to an embodiment;

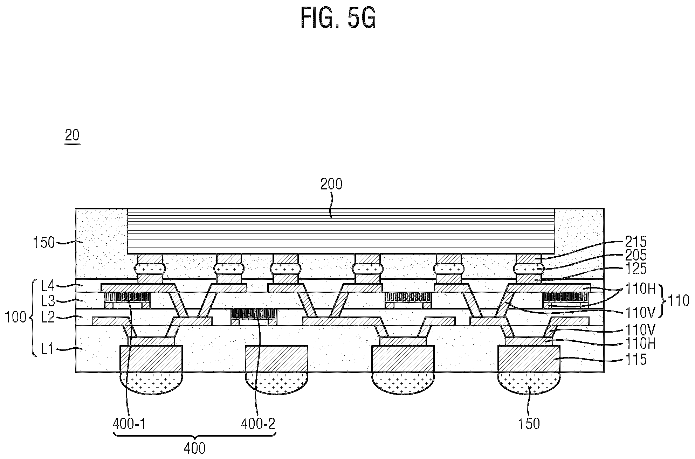

FIG. 5G illustrates an intermediate semiconductor package after step 70 of FIG. 4, according to an embodiment; and

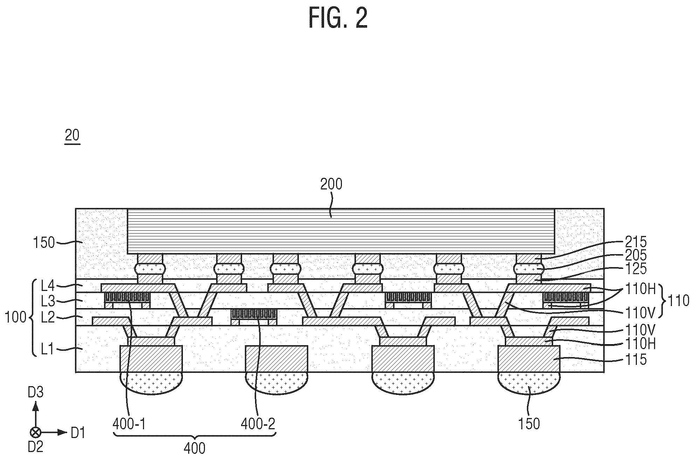

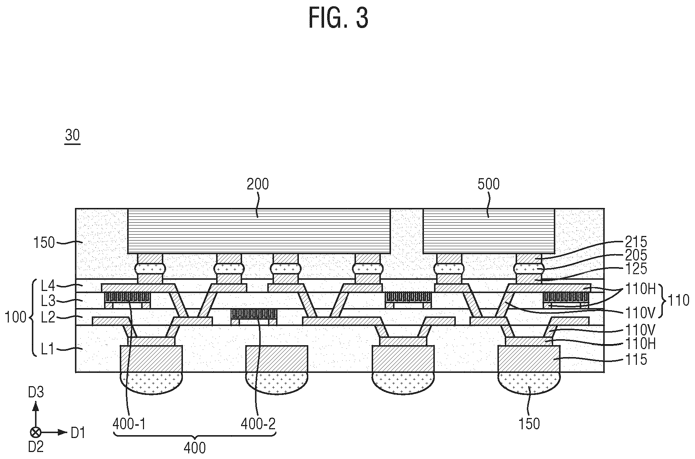

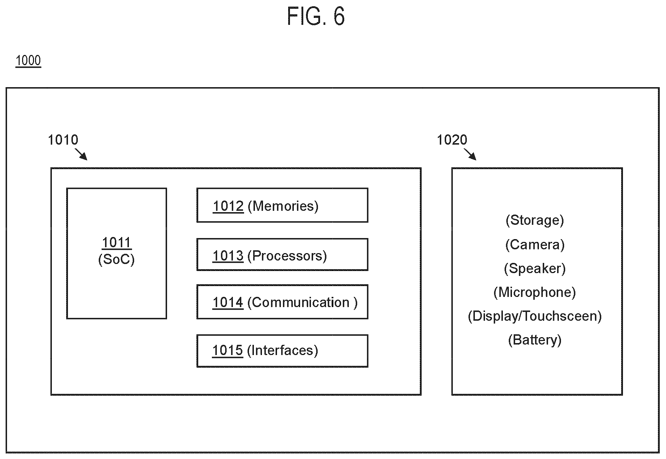

FIG. 6 is a schematic block diagram illustrating an electronic device including at least one of the semiconductor packages shown in FIGS. 2 and/or 3, according to an example embodiment.

### DETAILED DESCRIPTION

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "first" element or a "second" element, respectively, as long as their structural relationship is clearly understood in the context of the descriptions. Similarly, the terms a "lower" element and an "upper" element may be respectively referred to as a "first" element and a "second" element with necessary descriptions to distinguish the two elements.

It will be understood that, although the terms "first," "second," "third," "fourth," "fifth," "sixth," etc. may be used herein to describe various elements, these elements should not be limited by these terms. These terms are only used to distinguish one element from another element. Thus, a first element discussed below could be termed a second element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, when a method of manufacturing an apparatus or structure is described as including a plurality of steps or operations, a certain step or operation described as being be performed later than another step or operation may be performed prior to or at the same time as the other step or operation unless the other step or operation is described as being performed prior to the step or operation. Further, the method may include additional steps or operations not mentioned in the description.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers included in a semiconductor package including a connection pad, an adhesive layer, an isolation layer, a barrier metal pattern, a seed layer, etc. may or may not be described in detail herein. For example, certain connection pads of a semiconductor chip connected to solder balls or bumps in a semiconductor package may be omitted herein when these structural elements are not related to the novel features of the embodiments. Also, descriptions of materials forming well-known structural elements may be omitted herein when those materials are not relevant to the novel features of the embodiments. Herein, the term "connection" between two structures or elements may refer to electrical connection therebetween. For example, connection between semiconductor chips, semiconductor packages, and/or semiconductor devices may refer to electrical connection of corresponding two or more elements to each other. Further, the term "isolation" between two structures or elements pertains to electrical insulation or separation therebetween. For example, isolation of wiring patterns from each other may mean that the wiring patterns are not electrically connected to each other.

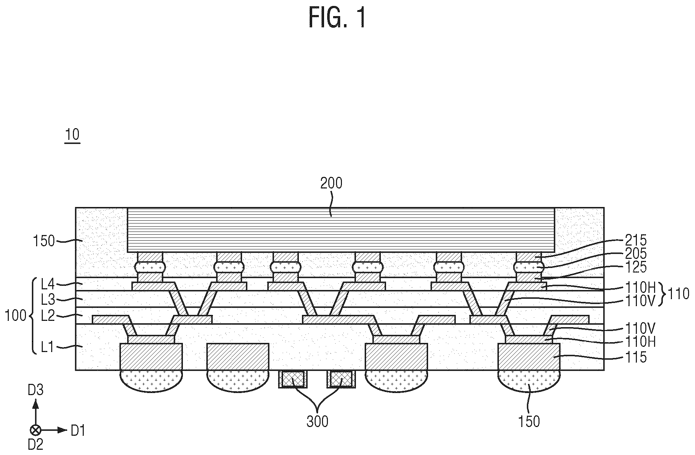

Herebelow, various embodiments of the disclosure are described in reference to FIGS. 1-6.

High-performance semiconductor chips such as a central processing unit (CPU), a graphic processing unit (GPU), an artificial intelligence (AI) chip, etc. consume a greater amount of power compared to other types of semiconductor chip such as a memory chip. For example, power consumption by these high-performance chips may reach a very high level (e.g., around 1000 W) for a thermal design power (TDP). The greater power consumption imposes challenges to designing a power delivery network (PDN) for the high-performance chips, and thus, there is an increased need to design a PDN with a low impedance across multiple frequency ranges when a semiconductor package including the high-performance chips is designed and manufactured.

A semiconductor device may include one or more semiconductor packages each of which includes one or more semiconductor chips. A semiconductor package may include one or more decoupling capacitors to control impedance and remove noise in a power delivery path to one or more semiconductors chip disposed on a redistribution layer in the semiconductor package. As a decoupling capacitor, a semiconductor package of the related art includes one or more capacitors such as a multilayer ceramic capacitor (MLCC), a metal-in-metal (MiM) capacitor, a deep trench capacitor (DTC), etc.

How to configure these decoupling capacitors in a semiconductor package may affect power-delivery performance of a semiconductor device including the semiconductor package in which various high-performance semiconductor chips requiring a greater amount of operation power are included.

FIG. 1 illustrates a schematic cross-section side view of semiconductor package including a plurality of decoupling capacitors, according to an embodiment.

Referring to FIG. 1, a semiconductor package 10 may include a redistribution layer 100, a semiconductor chip 200 disposed vertically above the redistribution layer 100 with a plurality of connection terminals 205 formed between the redistribution layer 100 and the semiconductor chip 200, and a plurality of decoupling capacitors 300 disposed on a bottom surface of the redistribution layer 100.

The semiconductor package 10 may be a fan-out wafer level package (FOWLP) which may be characterized by one or more redistribution layers connecting one or more semiconductor chips or dies to a package substrate. The FOWLP allows for a smaller package size and improved electrical performance compared to other types of semiconductor package such as a fan-in package, a wire-bond package, etc. In the FOWLP, a lateral edge of the package profile may be extended in a D1 direction beyond a lateral edge of a semiconductor chip included therein as shown in FIG. 1. For example, a lateral width of the redistribution layer 100 formed below the semiconductor chip 200 may be greater than that of the semiconductor chip 200. The decoupling capacitors 300 may be provided in the semiconductor package 10 to control impedance and reduce noise applied to the semiconductor chip 200 through the redistribution layer 100.

The semiconductor chip 200 may be one of a system-on-chip (SoC), a microprocessor chip such as a CPU, a GPU, a neural processing unit (NPU), etc., an AI chip, an application-specific integrated circuit (ASIC) chip, an image sensor chip, a power management chip, a memory chip, not being limited thereto. The SoC may include a CPU, a GPU, an NPU or an AI module.

The redistribution layer 100 may include a plurality of wiring patterns 110, lower connection patterns 115 and upper connection patterns 125 connected to each other through the wiring patterns included in a plurality of dielectric layers, for example, first to fourth dielectric layers L1-L4 which are vertically stacked and connected in this order, as shown in FIG. 1.

Each of the wiring patterns 110 included in the dielectric layers L1-L4 may include at least one line part 110H and/or at least one via part 110V connected to each other in a single dielectric layer or across two or more dielectric layers among the dielectric layers L1-L4. For example, a vertical thickness of one line part 110H of the wiring pattern 110 may range 2 to 8 micrometers (µm), and a vertical thickness of each of the dielectric layers L1-L4 may range 3 to 10 micrometers, not being limited thereto. Here, the vertical thickness refers to a thickness measured in a D3 direction that intersects the D1 direction and a D2 direction shown in FIG. 1. Thus,, in the dielectric layers L1-L4, one of a top surface and a bottom surface of a line part 110H of the wiring pattern 110 may be disposed within a single dielectric layer, and the other of the top surface and the bottom surface of the line part 110H may be disposed within the single dielectric layer or coplanar with a top surface or a bottom surface of the single dielectric layer. The wiring patterns 110 may also be referred to as wiring traces.

The number of the dielectric layers forming the redistribution layer 100 is four (4) in the present embodiment. However, the disclosure is not limited thereto, and more or less than four (4) dielectric layers may form the redistribution layer 100, according to other embodiments.

A molding layer 150 may be formed to surround the semiconductor chip 200 and fill an underlying gap between the semiconductor chip 200 and the underlying redistribution layer 100.

The redistribution layer 100 may connect a plurality of chip connection pads 215 formed on a bottom surface of the semiconductor chip 200 to a plurality of external terminals 105 on a bottom surface of the redistribution layer 100 so that the semiconductor chip 200 may be connected to one or more external devices or other semiconductor packages. For example, each of the lower connection patterns 115 of the redistribution layer 100 may have at least a portion which is exposed through the bottom surface of the redistribution layer 100 and connected to one of the external terminals 105. Further, each of the upper connection patterns 125 may have at least a portion which is exposed through a top surface of the redistribution layer 100 and connected to one of the chip connection pads 215 through one of the connection terminals 205. The connection terminal 205 and the external terminal 105 may be a solder ball or bump, not being limited thereto.

The wiring patterns 110 may be formed of a metallic material such as copper (Cu), not being limited thereto. The lower connection patterns 115 and the upper connection patterns 125 may be formed of a metallic material such as copper (Cu), aluminum (Al), tungsten, (W), cobalt (Co), ruthenium (Ru), molybdenum (Mo), titanium (Ti), tantalum (Ta), or their compound, not being limited thereto. The connection terminals 205, the bonding pads 215 and the external terminals 105 may be formed of a metallic material such as copper (Cu), tin (Sb), lead (Pb), silver (Ag), or their compound, not being limited thereto. The wiring patterns 110, the lower connection patterns 115, the upper connection patterns 125, the connection terminals 205, the bonding pads 215, and the external terminals 105 may be formed of the same or different metallic materials.

Each of the dielectric layers L1-L4 may be formed of an organic material such as a photosensitive polymer, for example, photosensitive polyimide, not being limited thereto, having insulation properties so that a wiring pattern may be electrically isolated from another wiring pattern in the redistribution layer 100.

As will be described later in reference to FIGS. 4 to 5A-5G, the dielectric layers L1-L4 may be formed at temporally different steps, and thus, there may exist a boundary, a connection surface or an interface between two adjacent dielectric layers even if they may be formed of the same material. However, there may not exist such boundary, connection surface or interface between the two adjacent dielectric layers even if they may be formed at temporally different steps at least because they may be formed of the same material and through the same process.

As each of the decoupling capacitors 300 is disposed on the bottom surface of the redistribution layer 100, it may be referred to as a land side capacitor (LSC). The decoupling capacitors 300 may be connected or not connected to the wiring patterns 110 in the redistribution layer 100. When the decoupling capacitor 300 is connected to the wiring patterns 110, it may be connected such that at least two terminals thereof are connected to the semiconductor chip 200 in parallel. Each of the decoupling capacitors 300 may have a size of hundreds of micrometers (µm), for example, about 1.0 × 0.5 × 0.35 mm for the 0402 MLCC, while each of the dielectric layers L1-L4 may have a much thinner vertical thickness ranging 3 to 10 micrometers. Thus, the semiconductor package 10 may be configured such that the decoupling capacitors 300 are disposed on the bottom surface of the redistribution layer 100 between the external terminals 105 which may be a solder ball or bump. According to another embodiment, however, the semiconductor package 10 may be configured to have a decoupling capacitor on a top surface thereof, in which case this capacitor may be referred to as a die side capacitors (DSC).

Still, however, the decoupling capacitors may not be limited to the MLCC, the MiM capacitor, or the deep trench capacitor, and may also not be necessarily disposed on the bottom or top surface of the redistribution layer 100, as described below.

FIG. 2 illustrates a schematic cross-section side view of semiconductor package including a plurality of decoupling capacitors, according to another embodiment.

Referring to FIG. 2, a semiconductor package 20 may include the same or similar structural elements and configuration as that of the semiconductor package 10 shown in FIG. 1 except the decoupling capacitors 300. Thus, duplicate descriptions thereof may be omitted and the same reference numerals referring to those structural elements are used herebelow, while different aspects of the semiconductor package 20 are described herebelow.

The semiconductor package 20 may be characterized by at least a plurality of integrated silicon capacitors (ISCs) 400 that are disposed inside the redistribution layer 100 as decoupling capacitors for the semiconductor package 20, compared to the capacitors 300 disposed on a bottom surface of the redistribution layer 100.

The ISC 400 may take a form of a vertical cylinder array including a plurality of capacitive vias between two or more connection terminals, and may have a very low profile, for example, about 0.5mm × 0.5mm × 2.0 µm. Thus, the vertical thickness of the ISC 400 in the D3 direction may be smaller than that of each of the dielectric layers L1-L4 which may range 3 to 10 micrometers, so that the ISC 400 may be embedded in each of the dielectric layers L1-L4, or across two or more of the dielectric layers L1-L4. Further, the ISC 400 may have a high capacitance density similar to that of the MLCC. For example, the ISC may have hundreds of nF/mm² capacitance values, e.g., 1350 or higher nF/mm².

Due to the above-described low profile and high capacitance density, the ISC 400 may be embedded inside the redistribution layer 100 at a desired location for the same functional purpose of the decoupling capacitors 300 shown in FIG. 1. As the ISC 400 may have a small thickness than each of the dielectric layers L1-L4, the ISC 400 may be included in one of these dielectric layers such that one of a top surface and a bottom surface of the ISC 400 is within the single dielectric layer (e.g., L2 or L3), and the other of the top surface and the bottom surface of the ISC 400 is within the signle dielectric layer or coplanar with a top surface or a bottom surface of the single dielectric layer.

The ISC 400 may be either a first ISC 400-1 or a second ISC 400-2. The first ISC 400-1 may be connected to the at least one of the wiring patterns 110. For example, the first ISC 400-1 may be interposed between a line part 110H of a wiring pattern 110 in one dielectric layer (e.g., L3) and a line part 110H of a wiring pattern 110 in an adjacent dielectric layer (e.g., L4). The line part 110H of the wiring pattern 110 in the dielectric layer L3 may be extended in the D2 direction while the line part 110H of the wiring pattern 110 in the dielectric layer L4 may be extended the D1 direction. These two wiring patterns 110 connected to the first ISC 400-1 in two adjacent dielectric layers may be connected to a power delivery path between a voltage source and the semiconductor chip 200. The power delivery path may include the external terminals 105, the lower connection patterns 115, the wiring patterns 110, the upper connection patterns 125, the connection terminals 205, and the chip connection pads 215. As another example, the second ISC 400-2 may be formed on a line part 110H extended in the D2 direction in one dielectric layer (e.g., L2 and L3), but may be not connected to the power delivery path connecting the voltage source to the semiconductor chip 200. Thus, the second ISC 400-2 may function as a dummy capacitor, which may only support the structural configuration of the redistribution layer 100.

The wiring patterns 110 may also connect the semiconductor chip 200 to another semiconductor chip or a circuit element in another semiconductor package or semiconductor device. For example, a signal routing path may be formed through one of the connection pads 215, one of the connection terminals 205, one of the upper connection patterns 125, one or more of the wiring patterns 110 connected to the one of the first ISCs 400-1, one of the lower connection patterns 115, and one of the external terminals 105.

While the thickness of each of the line part 110H of the wiring pattern 100 and the ISC 400 may be smaller than a signal dielectric layer among the dielectric layers L1-L4, the wiring pattern 100 with the ISC 400 thereon may also have a thickness small than or equal to that of the single dielectric layer. For example, while a bottom surface of the line part 110H of the wiring pattern 100 extended in the D2 direction in the third dielectric layer L3 may be coplanar with a boundary between the third dielectric layer L3 and the second dielectric layer L2, a top surface of the ISC 400 formed on this line part 110H of the wiring pattern 100 may be coplanar with a boundary between the third dielectric layer L3 and the fourth dielectric layer L4. Thus, a sum thickness of the line part 110H of the wiring pattern 110 and the IDC 400 in the third dielectric layer L3 may be equal to the thickness of the dielectric layer L3. However, the disclosure is not limited thereto, and the wiring pattern 100 with the ISC 400 thereon may have a thickness greater or smaller than that of a single dielectric layer in the redistribution layer 100 according to embodiments. Still, however, the sum thickness of the line part 110H of the wiring pattern 110 and the IDC 400 may be smaller than a thickness of the redistribution layer 100 according to embodiments, Further, a sum thickness of the wiring pattern 110 including the line part 110H and the via part 110V may be smaller than the thickness of the redistribution layer 100 according to embodiments.

The ISC 400 having a high capacitance density may be disposed in the redistribution layer 100 sufficiently close to the semiconductor chip 200, for example, closer to the top surface than the lower surface of the redistribution layer 100, to better control impedance and noise applied to the semiconductor chip 200, thereby improving power delivery performance.

Further, as the semiconductor package 20 may dispense with DSCs or LSCs like the capacitors 300 in the semiconductor package 10 which are disposed on the top surface or the bottom surface of the redistribution layer 100 as shown in FIG. 1, an overall size of the semiconductor package 20 may be reduced. For example, while the external terminal 105, which may be a solder ball or bump, may form a ball grid array (BGA) of the semiconductor package 10 and 20, removal of the capacitors 300, which are LSCs, formed between the external terminals 105 on the bottom surface of the redistribution layer 100 may reduce constraints on a package design including a ball design for a BGA semiconductor package.

In the semiconductor package 10 shown in FIG. 1, a height in the D3 direction of the external terminal 105 of the semiconductor package 100 may be greater than that of the capacitor 300 formed on the bottom surface of the redistribution layer 100 at a side of the external terminal 105 so that the capacitor 300 may not be physically affected by connection of the semiconductor package 10 with another device or package through the external terminal 1005. However, in the semiconductor package 20 of the present embodiment, the height of the external terminal 105 may not be constrained because there is no such capacitor 300 on the bottom surface of the redistribution layer 100. For example, the external terminals 105 may be formed by smaller-sized solder balls at a smaller pitch and profile, which helps reduce an overall stack-up height of the semiconductor package 20.

The above embodiment of disposing the ISCs 400 inside the redistribution layer 100 may also apply to a land grid array (LGA) semiconductor package, that is, the semiconductor package 20 without the external terminals 105 (solder balls or bumps). In this case, the lower connection patterns 115 may form the LGA, and elimination of the capacitors 300 from the bottom surface of the redistribution layer 100 as an LSC may remove a need of a cavity inside an original equipment manufacturer (OEM) socket to improve a structural integrity with the OEM socket. Thus, manufacturing simplicity and cost reduction may also be achieved.

Moreover, due to the low impedance and the high capacitance density of the ISCs 400 in the semiconductor package 20 having a reduced footprint may better serve implementation of the high performance processors such as CPU, GPU, AI chips, etc. requiring high power consumption in a semiconductor package.

In the above embodiments, one redistribution layer, that is, the redistribution layer 100, is formed in the semiconductor package 20 to connect the semiconductor chip 200 to a voltage source or another semiconductor device or package through the external terminals 105. However, one or more additional redistribution layers may be formed above, below or at a side of the redistribution layer 100 in the semiconductor package 20 to provide at least one additional redistribution path to the semiconductor chip 200, according to embodiments. For example, the semiconductor chip 200 may be connected to another circuit element or semiconductor chip in another semiconductor package or device through the additional redistribution path provided by the additional redistribution layers in the semiconductor package 20. Here, the additional redistribution path may be a power delivery path or a signal routing path from or to the semiconductor package 20.

As one or more additional redistribution layers are connected to the semiconductor chip 200, a length of the power delivery path or the signal routing path may also increase, which may subsequently increase impedance and/or noise in the semiconductor package 20. However, one or more ISCs 400 may also be included in the additional redistribution layers to reduce the impedance and/or noise, and suppress increase of the entire size of the semiconductor package 20, according to embodiments.

In the meantime, the redistribution layer 100 with the ISCs 400 embedded therein may be disposed vertically above the semiconductor package 20 with corresponding connection patterns and terminals therebetween, thereby to form a different semiconductor package, according to another embodiment. In this embodiment, the ISCs 400 may be disposed in the redistribution layer 100 to be closer to a bottom surface of the redistribution layer 100 than a top surface thereof to better control impedance and noise applied to the semiconductor chip 200 disposed vertically below the redistribution layer 100.

Further, two or more semiconductor chips may be formed vertically above or below a redistribution layer including ISCs with corresponding connection patterns and terminals therebetween. FIG. 3 illustrates a schematic cross-section side view of semiconductor package including a plurality of decoupling capacitors, according to still another embodiment.

Referring to FIG. 3, a semiconductor package 30 may include the same or similar structural elements including the ISCs 400 and configuration as that of the semiconductor package 20. However, the semiconductor package 30 may be characterized in that another semiconductor chip 500 may be disposed vertically above the redistribution layer 100 within the lateral edges of the package profile. Thus, duplicate descriptions thereof may be omitted, and the same reference numerals referring to those structural elements are used herebelow.

Similar to the semiconductor package 20, the semiconductor package 30 may include the ISCs 400 inside the redistribution layer 100, and the ISCs 400 may each be either the ISC 400-1 or the ISC 400-2 as described above in reference to FIG. 2. However, in the semiconductor package the ISCs 400-1 may be connected to the semiconductor chips 200 and 500 to control impedance and noise applied to these two chips, respectively. The semiconductor package 30 may also provide a reduced footprint like the semiconductor package 20 as the LSCs or DSCs may not be included in the semiconductor package 30.

In the semiconductor package 30, the semiconductor chips 200 and 500 may be connected to each other through the wiring patterns 110 in the redistribution layer 100, in which case, the semiconductor chips 200 and 500 may be connected to the same one or more ISCs 400, and these ISCs 400 may be connected to a voltage source to reduce impedance and noise in the power delivery path. Additionally or alternatively, these ISCs 400 may be included in a signal routing path between the two semiconductor chips 200 and 500 to reduce impedance and noise in the signal routing path.

In FIG. 3, the two semiconductor chips 200 and 500 are formed vertically above one redistribution layer, that is, the redistribution layer 100, which includes the ISCs 400 in the semiconductor package 30. However, the disclosure is not limited thereto, and the semiconductor package 30 may be configured such that one or more additional redistribution layers may be formed above, below or at a side of the redistribution layer 100 in the semiconductor package 30 to provide at least one additional redistribution path to at least one of the semiconductor chips 200 and 500, according to embodiments. For example, at least one of the semiconductor chips 200 and 500 may be connected to another circuit element or semiconductor chip in another semiconductor package or device through the additional redistribution path provided by the additional redistribution layers in the semiconductor package 30.

As one or more additional redistribution layers are connected to at least one of the semiconductor chips 200 and 500, a length of the power delivery path or the signal routing path may also increase, which may subsequently increase impedance and/or noise in the semiconductor package 30. However, one or more ISCs 400 may also be included in the additional redistribution layers to reduce the impedance and/or noise and suppress increase of the entire size of the semiconductor package 30, according to embodiments.

Further, FIG. 3 shows that the semiconductor chips 200 and 500 are disposed side by side at a same level above the redistribution layer 100 in the semiconductor package 30. However, the disclosure is not limited thereto, and the semiconductor chips 200 and 500 may be formed at different levels above the redistribution layer 100, according to embodiments. For example, one or more additional redistribution layers may be formed below a higher-level semiconductor chip among the two semiconductor chips 200 and 500, and the additional redistribution layers may provide at least one additional redistribution path to the semiconductor package 30. Similar to the above embodiment, one or more ISCs 400 may be included in the additional redistribution layers to reduce the impedance and/or noise, and suppress increase of the entire size of the semiconductor package 30.

Herebelow, a method of manufacturing a semiconductor package including one or more ISCs is provided in reference to FIG. 4 and FIGS. 5A-5G.

FIG. 4 illustrates a flowchart for a method of manufacturing a semiconductor package including one or more ISCs, according to embodiments, and FIGS. 5A-5G illustrate intermediate semiconductor packages after respective steps of manufacturing a semiconductor package including one or more ISCs based on the flowchart of FIG. 4, according to embodiments.

The semiconductor package manufactured through the method described herebelow may be the same as or correspond to the semiconductor package 20 shown in FIG. 2, and thus, duplicate descriptions may be omitted and the same reference numerals referring to the structural elements of the semiconductor package 20 are used herebelow.

In step S10, the first dielectric layer L1 may be formed on a carrier substrate 101 through a coating or deposition process, as shown in FIG. 5A. Further, a first photolithography/masking/etching/deposition operation may be performed on the first dielectric layer L1 to form the lower connection patterns 115, the line part 110H and the via part 110V of each the wiring patterns 110 connected to the lower connection pattern 115 in the first dielectric layer L1. In addition, the line parts 110H of the wiring patterns 110 for the second dielectric layer L2 to be formed in a later step above the dielectric layer L1 may also be formed by the first photolithography/masking/etching/deposition operation in this step. Some of these line parts 110H for the second dielectric layer L2 may be formed to be extended in the D1 direction and connected to the lower connection patterns 115 through the wiring patterns 110 in the first dielectric layer L1, and some of these line parts 110H may be formed to be extended in the D2 direction and connected to the ISC 400 in a later step.

The first dielectric layer L1 may be patterned through, for example, lithography, laser drilling, reactive ion etching (RIE), etc., to form via openings which are subsequently filled in by depositing one or more metallic materials through, for example, electroplating, atomic layer deposition (ALD), physical vapor deposition (PVD), chemical vapor deposition (CVD), plasma enhanced CVD (PECVD), a combination thereof, etc., not being limited thereto, to form the lower connection patterns 115 and the wiring patterns 110. The lower connection patterns 115 may be formed such that bottom surfaces thereof contact the carrier substrate 101.

The metallic materials forming the lower connection patterns 115 and the wiring patterns 110 may be selected from among copper (Cu), aluminum (Al), tungsten, (W), cobalt (Co), ruthenium (Ru), molybdenum (Mo), titanium (Ti), tantalum (Ta), or their compound, not being limited thereto. The lower connection patterns 115 and the wiring patterns 110 may be formed of the same or different materials.

The carrier substrate 101 on which the first dielectric layer L1 is formed may be, for example, a glass, silicon or ceramic substrate, not being limited thereto. The coating or deposition process to form the dielectric layer L1 may use spin coating, slit coating, CVD, etc. of the organic material such as a photosensitive polymer, for example, photosensitive polyimide, not being limited thereto.

In step S20, the second ISC 400-2 may be formed on at least one line part 110H of at least one selected wiring pattern 110 for the dielectric layer L2, as shown in FIG. 5B. The second ISC 400-2 may be formed on the wiring pattern 110 extended in the D2 direction through, for example, soldering, not being limited thereto.

The second ISC 400-2 formed in this step may be a dummy capacitor which is not connected to the power delivery path in the semiconductor package 20 to be completed in a later step based on an intermediate semiconductor package obtained in this step.

In step S30, the second dielectric layer L2 may be formed on the first dielectric L1 by the same or similar coating or deposition process performed in step S10 to surround the wiring patterns 110 in the second dielectric layer L2, as shown in FIG. 5C. Further, a second photolithography/masking/etching/deposition operation may be performed to form the line parts 110H of the wiring patterns 110 for the third dielectric layer L3 and the via parts 110V of the wiring patterns 110 connected to the line part 110H thereof in the second dielectric layer L2. These line parts 110h may be formed to be extended in the D2 direction and connected to the ISCs 400 in a later step.

In step S40, the ISCs 400-1 and another ISC 400-2 may be formed on the respective line parts 110H of selected wiring patterns 110 for the third dielectric layer L3 through soldering as in step S20, not being limited thereto, as shown in FIG. 5D

Like the ISC 400-2 formed in the second dielectric layer L2 in step S20, the ISC 400-2 formed in this step may not be connected to the power delivery path in the semiconductor package 20 to be completed in a later step. However, the ISCs 400-1 formed in this step may be connected to the power delivery path in the semiconductor package 20.

In step S50, the third dielectric layer L3 may be formed on the second dielectric layer to surround the wiring patterns 110 formed in step S40 and the ISCs 400-1 and 400-2 thereon, as shown in FIG. 5E.

Further, the fourth dielectric layer L4 may be formed on the third dielectric layer L3 by the same or similar coating or deposition process performed in steps S10 and S30, thereby completing the redistribution layer 100. In addition, a third photolithography/masking/etching/deposition operation may be performed on the fourth dielectric layer L4 to form the remaining line parts 110H of the wiring patterns 110 on the respective via parts 110V of the wiring patterns 110 in the third dielectric layer L3, and form the upper connection patterns 125 on these line parts 110H of the wiring patterns 110.

In step S60, the connection terminals 205 may be formed on the upper connection patterns 125 respectively, and the semiconductor chip 200 may be seated on the redistribution layer 100 by bonding the chip connection pads 215 thereof to the connection terminals 205, respectively, as shown in FIG. 5F. Further, the molding layer 150 may be formed to surround the semiconductor chip 200 and fill an underlying gap between the semiconductor chip 200 and the underlying redistribution layer 100.

When the connection terminals 205 are solder balls or bumps, solder transfer, ball placement, electroplating, printing, or the like may be used to form the connection terminals 205 on the upper connection patterns 125. Bonding the semiconductor chip 200 to the connection terminals 205 may be performed through, for example, soldering. The connection terminals 205 and the bonding pads 215 may be formed of the same or different metallic materials selected from among copper (Cu), tin (Sb), lead (Pb), silver (Ag), or their compound, not being limited thereto.

In step S70, as shown in FIG. 5G, the carrier substrate 101 may be removed from the intermediate semiconductor package obtained in the previous step, and the external terminals 105 may be formed on the bottom surface of the redistribution layer 100 to be connected to the lower connection patterns 115, respectively, thereby forming the semiconductor package 20 shown in FIG. 2.

The external terminals 105 may be formed of a metallic material such as copper (Cu), tin (Sb), lead (Pb), silver (Ag), or their compound, not being limited thereto. The external terminals may be formed of the same or different materials from the connection terminals 205.

The removal of the carrier substrate 101 may be performed through, for example, mechanical grinding, etc., and the connection of the external terminals 105 to the lower connection patterns 115 may be performed through, for example, soldering, etc.

FIG. 6 is a schematic block diagram illustrating an electronic system including a plurality of semiconductor packages shown in FIGS. 2 and/or 3, according to an example embodiment.

Referring to FIG. 6, an electronic device 1000 may include a printed circuit board (PCB) 1010, which may be a motherboard, on which a plurality of semiconductor packages 1011-1015 are mounted. The electronic device 1000 may also include a plurality of other components 1020. The PCB 1010 may be a package substrate which includes a substrate core formed of an epoxy resin and a plurality of through vias penetrating the substrate core. The package substrate may also include a plurality of connection terminals formed on a front side surface and/or a backside surface, and connected to the through vias. The package substrate may be connected to a redistribution layer such as the redistribution layer 100 of FIG. 2 or 3.

The semiconductor package 1011 may include a SoC which may include at least one of a CPU, a GPU, an AI module, a modem, one or more memory units, a power management unit, etc. to control overall operations of the electronic device 1000. The other semiconductor packages 1012-1015 may include memory chips, various other processor chips, communication chips and interface chips, respectively. The communication chips included in the semiconductor package 1014 may be configured to also perform wireless or wire communication functions in association with the SoC. At least one of the semiconductor packages 1011-1015 may be implemented by the semiconductor package 20 or 30 shown in FIGS. 2A and 3A..

The other components 1020 included in the electronic device 100 may include a storage, a camera module, a speaker, a microphone, a display, a battery, etc. The storage may be configured to store user data. The storage may be an embedded multimedia card (eMMC), a solid state drive (SSD), a universal flash storage (UFS) device, etc. The display may be implemented to display data processed by the SoC and/or to receive data through a touchscreen panel of the display.

## Claims

1. A semiconductor device (20) comprising:
a redistribution layer (100) comprising an insulation layer (L1 to L4) in which a first wiring pattern (110) is formed;
a first semiconductor chip (200), on the redistribution layer (100) in a first direction (D3), connected to the first wiring pattern (110); and
a first capacitor (400, 400-1, 400-2) disposed in the redistribution layer (100), wherein
the first capacitor (400, 400-1, 400-2) is an integrated silicon capacitor embedded in the insulating layer (L1 to L4).

2. The semiconductor device (20) of claim 1, wherein the first capacitor (400, 400-1, 400-2) is disposed in the insulation layer (L1 to L4) such that one of a top surface and a bottom surface of the first capacitor (400, 400-1, 400-2) is within the insulation layer (L1 to L4) in the first direction (D3), and the other of the top surface and the bottom surface of the first capacitor (400, 400-1, 400-2) is within the insulation layer (L1 to L4) in the first direction (D3) or coplanar with a top surface or a bottom surface of the insulation layer (L1 to L4).

3. The semiconductor device (20) of claim 2, wherein the top surface of the first capacitor (400, 400-1, 400-2) is coplanar with the top surface of the insulation layer (L1 to L4).

4. The semiconductor device (20) of any one of claims 1 to 3, wherein the first capacitor (400, 400-1, 400-2) is disposed to be closer to a top surface of the redistribution layer (100) facing the first semiconductor chip (200) than a bottom surface of the redistribution layer (100) facing away from the first semiconductor chip (200) in the first direction (D3).

5. The semiconductor device (20) of any one of claims 1 to 4, wherein the first capacitor (400, 400-1) is connected to the first wiring pattern (110) which is connected to the first semiconductor chip (200).

6. The semiconductor device (20) of claim 5, further comprising a second capacitor (400, 400-1) connected to a second wiring pattern (110) formed in the redistribution layer (100),
wherein the second wiring pattern (110) is electrically isolated from any wiring pattern (110) connected to the first semiconductor chip (200).

7. The semiconductor device (20) of any one of claims 1 to 6, wherein the first capacitor (400, 400-1) is connected to the first wiring pattern (110),
wherein the first wiring pattern (110) is electrically isolated from any other wiring pattern (110) connected to the first semiconductor chip (200).

8. The semiconductor device (20) of any one of claims 1 to 5, further comprising:
a second semiconductor chip (500), on the redistribution layer (100) in a first direction (D3), connected to a second wiring pattern (110) in the redistribution layer (100); and
a second capacitor (400, 400-1) disposed in the redistribution layer (100).

9. The semiconductor device (20) of claim 8, wherein the first capacitor (400, 400-1) and the second capacitor (400, 400-1) are connected to the first wiring pattern (110) and the second wiring pattern (110), respectively, and
wherein at least one of the first wiring pattern (110) and the second wiring pattern (110) is connected to at least one of the first semiconductor chip (200) and the second semiconductor chip (500).

10. The semiconductor device (20) of claim 8 or 9, wherein the first capacitor (400, 400-1) and the second capacitor (400, 400-1) are disposed closer to a top surface of the redistribution layer (100) facing the first semiconductor chip (200) and the second semiconductor chip (500) than an opposite outer surface of the redistribution layer (100) facing away from the first semiconductor chip (200) and the second semiconductor chip (500).

11. The semiconductor device (20) of any one of claims 1 to 10, further comprising a connection terminal (205) between the redistribution layer (100) and the first semiconductor chip (200),
wherein the connection terminal (205) comprises a solder ball or a bump connecting the first wiring pattern (110) or another wiring pattern in the redistribution layer (100) to the first semiconductor chip (200).

12. The semiconductor device (20) according to any one of the preceding claims, wherein the first capacitor (400, 400-1) is a decoupling capacitor.

13. The semiconductor device according to any one of claims 1 to 4, wherein the first capacitor (400, 400-2) is a dummy capacitor.

14. An electronic device comprising at least one of the semiconductor devices (20) according to any one of the preceding claims.

## Patentansprüche

1. Halbleiterbauelement (20), aufweisend:
eine Umverdrahtungsschicht (100), die eine Isolierschicht (L1 bis L4) aufweist, in der ein erstes Verdrahtungsmuster (110) ausgebildet ist;
einen ersten Halbleiterchip (200), der auf der Umverdrahtungsschicht (100) in einer ersten Richtung (D3) mit dem ersten Verdrahtungsmuster (110) verbunden ist; und
einen ersten Kondensator (400, 400-1, 400-2), der in der Umverdrahtungsschicht (100) angeordnet ist, wobei
der erste Kondensator (400, 400-1, 400-2) ein integrierter Siliziumkondensator ist, der in die Isolierschicht (L1 bis L4) eingebettet ist.

2. Halbleiterbauelement (20) nach Anspruch 1, wobei der erste Kondensator (400, 400-1, 400-2) in der Isolierschicht (L1 bis L4) so angeordnet ist, dass eine von einer oberen Oberfläche und einer unteren Oberfläche des ersten Kondensators (400, 400-1, 400-2) in der ersten Richtung (D3) innerhalb der Isolierschicht (L1 bis L4) ist, und die andere von der oberen Oberfläche und der unteren Oberfläche des ersten Kondensators (400, 400-1, 400-2) in der ersten Richtung (D3) innerhalb der Isolierschicht (L1 bis L4) ist oder koplanar mit einer oberen Oberfläche oder einer unteren Oberfläche der Isolierschicht (L1 bis L4) ist.

3. Halbleiterbauelement (20) nach Anspruch 2, wobei die obere Oberfläche des ersten Kondensators (400, 400-1, 400-2) koplanar mit der oberen Oberfläche der Isolierschicht (L1 bis L4) ist.

4. Halbleiterbauelement (20) nach einem der Ansprüche 1 bis 3, wobei der erste Kondensator (400, 400-1, 400-2) näher an einer oberen Oberfläche der Umverdrahtungsschicht (100), die dem ersten Halbleiterchip (200) zugewandt ist, als an einer unteren Oberfläche der Umverdrahtungsschicht (100) angeordnet ist, die in der ersten Richtung (D3) von dem ersten Halbleiterchip (200) abgewandt ist.

5. Halbleiterbauelement (20) nach einem der Ansprüche 1 bis 4, wobei der erste Kondensator (400, 400-1) mit dem ersten Verdrahtungsmuster (110) verbunden ist, das mit dem ersten Halbleiterchip (200) verbunden ist.

6. Halbleiterbauelement (20) nach Anspruch 5, ferner aufweisend einen zweiten Kondensator (400, 400-1), der mit einem zweiten Verdrahtungsmuster (110) verbunden ist, das in der Umverdrahtungsschicht (100) ausgebildet ist,
wobei das zweite Verdrahtungsmuster (110) von jedem Verdrahtungsmuster (110), das mit dem ersten Halbleiterchip (200) verbunden ist, elektrisch isoliert ist.

7. Halbleiterbauelement (20) nach einem der Ansprüche 1 bis 6, wobei der erste Kondensator (400, 400-1) mit dem ersten Verdrahtungsmuster (110) verbunden ist,
wobei das erste Verdrahtungsmuster (110) von jedem anderen Verdrahtungsmuster (110) elektrisch isoliert ist, das mit dem ersten Halbleiterchip (200) verbunden ist.

8. Halbleiterbauelement (20) nach einem der Ansprüche 1 bis 5, ferner aufweisend:
einen zweiten Halbleiterchip (500), der auf der Umverdrahtungsschicht (100) in einer ersten Richtung (D3) mit einem zweiten Verdrahtungsmuster (110) in der Umverdrahtungsschicht (100) verbunden ist; und
einen zweiten Kondensator (400, 400-1), der in der Umverdrahtungsschicht (100) angeordnet ist.

9. Halbleitervorrichtung (20) nach Anspruch 8, wobei der erste Kondensator (400, 400-1) und der zweite Kondensator (400, 400-1) jeweils mit dem ersten Verdrahtungsmuster (110) und dem zweiten Verdrahtungsmuster (110) verbunden sind, und
wobei zumindest eines von dem ersten Verdrahtungsmuster (110) und dem zweiten Verdrahtungsmuster (110) mit zumindest einem von dem ersten Halbleiterchip (200) und der zweiten Halbleiterchip (500) verbunden ist.

10. Halbleiterbauelement (20) nach Anspruch 8 oder 9, wobei der erste Kondensator (400, 400-1) und der zweite Kondensator (400, 400-1) näher an einer oberen Oberfläche der Umverdrahtungsschicht (100), die dem ersten Halbleiterchip (200) und dem zweiten Halbleiterchip (500) zugewandt ist, angeordnet sind als an einer gegenüberliegenden äußeren Oberfläche der Umverdrahtungsschicht (100), die von dem ersten Halbleiterchip (200) und dem zweiten Halbleiterchip (500) abgewandt ist.

11. Halbleiterbauelement (20) nach einem der Ansprüche 1 bis 10, ferner aufweisend einen Verbindunganschluss (205) zwischen der Umverdrahtungsschicht (100) und dem ersten Halbleiterchip (200),
wobei der Verbindungsanschluss (205) eine Lötkugel oder einen Lötpunkt umfasst, die/der das erste Verdrahtungsmuster (110) oder ein anderes Verdrahtungsmuster in der Umverdrahtungsschicht (100) mit dem ersten Halbleiterchip (200) verbindet.

12. Halbleiterbauelement (20) nach einem der vorhergehenden Ansprüche, wobei der erste Kondensator (400, 400-1) ein Entkopplungskondensator ist.

13. Halbleiterbauelement nach einem der Ansprüche 1 bis 4, wobei der erste Kondensator (400, 400-2) ein Dummy-Kondensator ist.

14. Elektronische Vorrichtung, die zumindest eines der Halbleiterbauelemente (20) nach einem der vorhergehenden Ansprüche aufweist.

## Revendications

1. Dispositif semi-conducteur (20) comprenant :
une couche de redistribution (100) comprenant une couche isolante (L1 à L4) dans laquelle est formé un premier motif de câblage (110) ;
une première puce semi-conductrice (200), sur la couche de redistribution (100) dans une première direction (D3), connectée au premier motif de câblage (110) ; et
un premier condensateur (400, 400-1, 400-2) disposé dans la couche de redistribution (100),
dans lequel le premier condensateur (400, 400-1, 400-2) est un condensateur intégré en silicium, incorporé dans la couche isolante (L1 à L4).

2. Dispositif semi-conducteur (20) selon la revendication 1, dans lequel le premier condensateur (400, 400-1, 400-2) est disposé dans la couche isolante (L1 à L4) de telle sorte que, dans la première direction (D3), l'une d'une surface supérieure et d'une surface inférieure du premier condensateur (400, 400-1, 400-2) se trouve à l'intérieur de la couche isolante (L1 à L4), et que l'autre de la surface supérieure et de la surface inférieure du premier condensateur (400, 400-1, 400-2) se trouve à l'intérieur de la couche isolante (L1 à L4) ou est coplanaire avec une surface supérieure ou une surface inférieure de la couche isolante (L1 à L4).

3. Dispositif semi-conducteur (20) selon la revendication 2, dans lequel la surface supérieure du premier condensateur (400, 400-1, 400-2) est coplanaire avec la surface supérieure de la couche isolante (L1 à L4).

4. Dispositif semi-conducteur (20) selon l'une quelconque des revendications 1 à 3, dans lequel le premier condensateur (400, 400-1, 400-2) est disposé, dans la première direction (D3), plus près d'une surface supérieure de la couche de redistribution (100) faisant face à la première puce semi-conductrice (200) que d'une surface inférieure de la couche de redistribution (100) faisant face à l'opposé de la première puce semi-conductrice (200).

5. Dispositif semi-conducteur (20) selon l'une quelconque des revendications 1 à 4, dans lequel le premier condensateur (400, 400-1) est connecté au premier motif de câblage (110) qui est connecté à la première puce semi-conductrice (200).

6. Dispositif semi-conducteur (20) selon la revendication 5, comprenant en outre un deuxième condensateur (400, 400-1) connecté à un deuxième motif de câblage (110) formé dans la couche de redistribution (100),
dans lequel le deuxième motif de câblage (110) est électriquement isolé de tout motif de câblage (110) connecté à la première puce semi-conductrice (200).

7. Dispositif semi-conducteur (20) selon l'une quelconque des revendications 1 à 6, dans lequel le premier condensateur (400, 400-1) est connecté au premier motif de câblage (110),
dans lequel le premier motif de câblage (110) est électriquement isolé de tout autre motif de câblage (110) connecté à la première puce semi-conductrice (200).

8. Dispositif semi-conducteur (20) selon l'une quelconque des revendications 1 à 5, comprenant en outre :
une deuxième puce semi-conductrice (500), sur la couche de redistribution (100) dans la première direction (D3), connectée à un deuxième motif de câblage (110) dans la couche de redistribution (100) ; et
un deuxième condensateur (400, 400-1) disposé dans la couche de redistribution (100).

9. Dispositif semi-conducteur (20) selon la revendication 8, dans lequel le premier condensateur (400, 400-1) et le deuxième condensateur (400, 400-1) sont connectés au premier motif de câblage (110) et au deuxième motif de câblage (110), respectivement, et
dans lequel au moins l'un du premier motif de câblage (110) et du deuxième motif de câblage (110) est connecté à au moins l'une de la première puce semi-conductrice (200) et de la deuxième puce semi-conductrice (500).

10. Dispositif semi-conducteur (20) selon la revendication 8 ou 9, dans lequel le premier condensateur (400, 400-1) et le deuxième condensateur (400, 400-1) sont disposés plus près d'une surface supérieure de la couche de redistribution (100) faisant face à la première puce semi-conductrice (200) et à la deuxième puce semi-conductrice (500) que d'une surface extérieure opposée de la couche de redistribution (100) faisant face à l'opposé de la première puce semi-conductrice (200) et de la deuxième puce semi-conductrice (500).

11. Dispositif semi-conducteur (20) selon l'une quelconque des revendications 1 à 10, comprenant en outre une borne de connexion (205) entre la couche de redistribution (100) et la première puce semi-conductrice (200),
dans lequel la borne de connexion (205) comprend une bille de soudure ou un plot, reliant le premier motif de câblage (110) ou un autre motif de câblage dans la couche de redistribution (100) à la première puce semi-conductrice (200).

12. Dispositif semi-conducteur (20) selon l'une quelconque des revendications précédentes, dans lequel le premier condensateur (400, 400-1) est un condensateur de découplage.

13. Dispositif semi-conducteur selon l'une quelconque des revendications 1 à 4, dans lequel le premier condensateur (400, 400-2) est un condensateur factice.

14. Dispositif électronique comprenant au moins l'un des dispositifs semi-conducteurs (20) selon l'une quelconque des revendications précédentes.
